# EUROPÄISCHE PATENTSCHRIFT

(11) **EP 3 320 352 B1**
(45) Veröffentlichungstag und Bekanntmachung des Hinweises auf die Patenterteilung: **18.09.2019**
(21) Anmeldenummer: 16738669.7
(22) Anmeldetag: 04.07.2016
(51) Int. Cl.: G01R 31/28

(54) **TESTEN VON DISKRETEN HALBLEITER-BAUELEMENTEN**
TESTING DISCRETE SEMICONDUCTOR COMPONENTS
TEST DE COMPOSANTS SEMI-CONDUCTEURS DISCRETS

(30) Priorität: 06.07.2015 DE 102015110898
(43) Veröffentlichungstag der Anmeldung: 16.05.2018
(73) Patentinhaber: EP Ants GmbH, 92342 Freystadt (DE)
(72) Erfinder: TAYLOR, Rick, 92342 Freystadt (DE); TAYLOR, Sebastian, 90584 Göggelsbuch (DE)
(74) Vertreter: Schneider, Andreas
(86) Internationale Anmeldenummer: PCT/EP2016/001139
(87) Internationale Veröffentlichungsnummer: WO 2017/005357

(56) Entgegenhaltungen:
- US-A- 5 821 505
- US-A1- 2006 245 161
- US-A1- 2011 226 442
- US-A1- 2015 109 009

## Beschreibung

Die Erfindung betrifft eine Testvorrichtung für ein diskretes Halbleiter-Bauelement. Darüber hinaus betrifft die Erfindung ein Verfahren zum Testen eines diskreten Halbleiter-Bauelements.

Aus dem Stand der Technik ist es bekannt, Halbleiter-Bauelemente, nachfolgend auch Chips genannt, vor ihrer Verwendung zu testen. Bei den Halbleiter-Bauelementen (Halbleiter-ICs) kann es sich beispielsweise um Transistoren, Dioden oder MOSFETs handeln. Die Halbleiter-Bauelemente werden hierzu extremen Umweltbedingungen ausgesetzt, um schwache und defekte Bauelemente identifizieren und aussondern zu können. Die Tests dienen mit anderen Worten in erster Linie der Qualitätssicherung.

Dabei werden die Bauelemente beispielsweise in sogenannte Einbrenntests (Burn-in-Tests) getestet. Dies erfolgt in der Regel in Testlabors. Bei fehlerhaften Bauelementen wird hierdurch ein Funktionsausfall (Zerstörung oder Fehlfunktion) provoziert. Solche Bauelemente werden dann aussortiert. Damit soll gewährleistet werden, daß die Halbleiter-Bauelemente auch bei kritischen Anwendungen, z. B. in der Luftfahrt oder im Kraftfahrzeugbereich sicher funktionieren.

Diese Tests können zum einen bereits erfolgen, wenn die Bauelemente noch in Form eines Wavers vorliegen. Andererseits werden auch einzelne, diskrete Halbleiter-Bauelemente getestet, wobei es sich dabei um ungehäuste Halbleiterchips (bare dies) handeln kann oder um Bauelemente, die bereits in einem Gehäuse verbaut sind.

Um die gewünschten Testtemperaturen zu erreichen, ist es bekannt, Wafer oder diskrete Bauelemente im Inneren eines Ofens aufzuheizen, der als Testbehälter dient. Dabei wird eine große Anzahl von Bauelementen gleichzeitig getestet, z. B. mehrere hundert Chips. Nachteilig dabei sind die langen Aufheiz- und Abkühlzeiten. Beim Testen auf Waver-Ebene ist zudem ein Erwärmen der Bauelemente mit Hilfe von strömenden Flüssigkeiten bekannt. Beim Test einzelner, diskreter Chips ist außerdem eine Temperierung mit Hilfe von heißer Luft bekannt. Nachteilig sind auch hier die geringen Aufheiz- und Abkühlraten.

Nachteilig an den bisher durchgeführten Test ist es darüber hinaus, daß zumeist nur statische Einbrenntests durchgeführt werden können. Dabei wird lediglich eine erhöhte Spannung an die Bauelemente angelegt und die Bauelemente werden einer hohen Testtemperatur ausgesetzt, beispielsweise +250°C. Die Durchführung dynamischer Tests, bei denen Testsignale an die Bauelemente angelegt und Testfunktionen ausgeführt werden, also ein mehr oder weniger vollständiger Zugriff auf alle Funktionen des zu testenden Bauteils möglich ist, ist hingegen bei den bekannten Testsystemen oftmals nicht möglich.

In US5821505A, US2011/226442A1, US2015/109009A1 und US2006/245161A1 sind herkömmliche Verfahren und Vorrichtungen zum Heizen und/oder Kühlen von Halbleiter-Bauelementen beschrieben.

Eine Aufgabe der vorliegenden Erfindung ist es, die Durchführung von Tests von Halbleiter-Bauelementen in temperierten Umgebungen zu vereinfachen und zu verbessern.

Diese Aufgabe wird durch eine Testvorrichtung nach Anspruch 1 bzw. ein Testverfahren nach Anspruch 7 gelöst. Vorteilhafte Ausführungen der Erfindung sind in den Unteransprüchen angegeben.

Die im Folgenden im Zusammenhang mit dem Verfahren erläuterten Vorteile und Ausgestaltungen gelten sinngemäß auch für die erfindungsgemäße Vorrichtung und umgekehrt.

Eine Grundidee der Erfindung ist es zunächst, das zu testende Halbleiter-Bauelement mit einer Kontaktfläche eines Heizelements direkt und unmittelbar mechanisch zu kontaktieren. Im Gegensatz zu einem indirekten Aufheizen, beispielsweise durch Wärmestrahlung, ist durch den erfindungsgemäßen Einsatz von einer Direktkontaktierung und einer damit verbundenen Wärmeleitung zwischen einer gezielt temperierbaren Kontaktfläche und dem Bauelement ein sehr schnelles Aufheizen des Bauelements möglich. Dies wird unter anderem durch einen geringen Wärmewiderstand zwischen Bauelement und Kontaktfläche erreicht, der sich insbesondere aufgrund der vorzugsweise flächigen Kontaktierung ergibt; mit anderen Worten liegt die Kontaktfläche des Heizelements vorzugsweise flächig an dem Halbleiter-Bauelement an. Die Wärmezufuhr kann darüber hinaus auch sehr zielgenau erfolgen, ohne daß unbeteiligte Komponenten der Testanordnung, insbesondere zu dem Halbleiter-Bauelement benachbarte Komponenten, miterwärmt werden müssen. Das Testen des Bauelements kann somit unter bestimmten Umständen bei höheren Temperaturen als üblich erfolgen, da auf die Temperaturbeständigkeit anderer, benachbarter Bauteile (Sockel, Platine usw.) keine Rücksicht mehr genommen werden muß. Damit das zu testende Bauelement durch die Kontaktierung mit dem der Kontaktfläche des Heizelements nicht beschädigt wird, erfolgt die Kontaktierung des Bauelements mit dem Heizelement vorzugsweise federgelagert, d.h. unter Anwendung eines federgelagerten Bauelements und/oder unter Anwendung eines federgelagerten Thermoaufsatzes bzw. Heizelements.

Der Thermoaufsatz ist mit dem Testsockel vorzugsweise unter Ausbildung einer lösbaren Verbindung verbindbar, beispielsweise mit Hilfe einer Verriegelung, wie sie dem Fachmann aus dem Stand der Technik bei Testsockeln bekannt ist. Vorzugsweise ist der Thermoaufsatz derart ausgeführt, daß er nach Art eines universellen Adapters an eine Vielzahl unterschiedlicher Testsockel angebracht werden kann. Die Erfindung kann dann unter Verwendung des Thermoaufsatzes mit verschiedenen Testsockeln verwirklicht werden. Vorzugsweise ist der Thermoaufsatz derart ausgeführt, daß er mit bereits vorhandenen Testsockeln verbunden und verwendet werden kann.

Der Thermoaufsatz ist vorzugsweise derart ausgeführt, daß das Heizelement mit seiner Kontaktfläche während des Testens, d.h. im Betriebszustand der Testvorrichtung, also dann, wenn der Thermoaufsatz mit dem Testsockel mit einem eingelegten Halbleiter-Bauelement verbunden ist, an wenigstens einer Seite des Halbleiter-Bauelement unter Ausbildung eines mechanischen Kontaktes flächig anliegt. Darunter ist zu verstehen, daß die Kontaktfläche des Heizelements an einer Seite des Bauelement selbst, wenn ungehäuste Chips getestet werden, oder an einer Seite eines den Chip aufnehmenden Chipgehäuses anliegt, wenn ein wie auch immer gehäuster Chip in dem Testsockel einliegt.

Bei dem wenigstens einen Heizelement, das in dem Thermoaufsatz zur Anwendung kommt und zum Heizen der Kontaktfläche dient, handelt es sich um ein keramisches Heizelement. Dabei handelt es sich um ein keramisches Schichtheizelement oder ein vollkeramisches Heizelement, vorzugsweise auf Basis von Siliziumnitrat oder Aluminiumnitrat bzw. aus Karbidkeramik. Bei der Anwendung keramischer Heizelemente werden die elektrisch halbleitenden Eigenschaften von Keramiken genutzt. Die Beheizung erfolgt direkt über den elektrischen Stromfluß. Hierdurch können hohe Aufheizraten erzielt werden.

Eine weitere Idee der Erfindung ist es, einen Kühlmechanismus in das Heizelement zu integrieren. Es ist somit ganz besonders vorteilhaft, daß das Heizelement sowohl zum Heizen als auch zum Kühlen der Kontaktfläche ausgebildet ist. Es wird mit anderen Worten ein kombiniertes Heiz- und Kühlelement verwendet. Dieses ist vorzugsweise sowohl zum wahlweisen Heizen und Kühlen als auch zum gleichzeitigen Heizen und Kühlen der Kontaktfläche ausgebildet.

Da anders ausgedrückt das Heizelement zugleich als Kühlelement dient, wird im Inneren des Heizelements ein zu der Kontaktfläche benachbarter Aufnahmeraum zur Aufnahme eines Kühlmittels vorgesehen. Dieser Aufnahmeraum dient dann als Kühlkammer zum Kühlen der beheizbaren Kontaktfläche. Zu diesem Zweck ist die Kühlkammer zur Aufnahme eines vorzugsweise fluiden Kühlmittels ausgebildet.

Da mit der Erfindung sowohl ein Erwärmen als auch ein Abkühlen der Kontaktfläche erreichbar ist, soll allgemein eine Zu- oder Abfuhr von Wärmeenergie (Wärme oder Kälte) gemeint sein, auch wenn nachfolgend lediglich von Wärmeeintrag, Wärmezufuhr usw. die Rede ist.

Als besonders vorteilhaft hat es sich erwiesen, wenn die Kühlkammer zum Durchströmen eines vorzugsweise fluiden Kühlmittels ausgebildet ist und zu diesem Zweck wenigstens eine Einlaßöffnung und wenigstens eine Auslaßöffnung aufweist. So kann die Kühlfunktion der Kühlkammer durch einen kontrollierten Ein- und/oder Auslaß des Kühlmittels gesteuert oder geregelt werden.

In einer Ausführungsform der Erfindung dient das kombinierte Heiz-/Kühlelement, welches nachfolgend zumeist weiterhin nur kurz als Heizelement bezeichnet wird, bzw. dienen Teile des Heizelements als Begrenzungen der Kühlkammer, insbesondere als deren Boden, Wände usw. Die von dem Heizelement aufzuheizende bzw. abzukühlende Masse wird damit auf ein Minimum reduziert. Vorteilhaft ist darüber hinaus, daß das integrierte Heiz- und Kühlelement einen Wärmetransfer auf kleinstem Raum ermöglicht. Da alle unnötigen Massen eliminiert sind und das Heizen und Kühlen des Halbleiter-Bauelements durch unmittelbaren Kontakt der Heiz- und Kühlfläche (Kontaktfläche) mit dem Bauelement erfolgt, kann sowohl ein sehr genaues Einstellen einer gewünschten Temperatur als auch eine schnelle und genaue Temperaturänderung erfolgen.

Zugleich ist eine Durchführung elektrischer Tests der Halbleiter-Bauelemente in einem weiten Temperaturbereich von beispielsweise -55°C bis +260°C möglich und eine gewünschte Temperaturänderung, beispielsweise von einer ersten Testtemperatur zu einer zweiten, abweichenden Testtemperatur, kann besonders schnell erfolgen. So lassen sich mit der vorliegenden Erfindung beispielsweise Temperaturänderungen von +25°C auf +250°C in 40 Sekunden, von +260°C auf +15°C in 70 Sekunden oder von +25°C auf -55°C in 160 Sekunden erreichen.

Das Kühlen der Kontaktfläche erfolgt in einer bevorzugten Ausführungsform der Erfindung unter Verwendung eines flüssigen Kühlmittels, welches in die Kühlkammer eingebracht wird und dort verdampft. Die Kühlkammer, die somit zugleich als Verdampferkammer dient, befindet sich daher vorzugsweise unmittelbar benachbart zu der Kontaktfläche und ermöglicht ein Durchströmen mit dem Kühlmittel. Dabei wird bedarfsweise stets neues Kühlmittel in die Kühlkammer zugeführt und bereits verdampftes Kühlmittel aus der Kühlkammer abgeführt.

Als Kühlmittel können verschiedene Kältemittel verwendet werden, so beispielsweise Stickstoff oder Helium. Aus Kosten- und Handhabungsgründen besonders vorteilhaft ist die Verwendung von Kohlendioxid (CO2-Flüssiggas).

In einer bevorzugten Ausführungsform der Erfindung wird das Kühlmedium aufgrund einer geeigneten Ausgestaltung der beteiligten Transportkomponenten nahezu verlustfrei in flüssiger Form bis zum Kühlort, der Kühlkammer im Inneren des Heizelements, transportiert und entfaltet erst dort durch Expansion seine volle Kühlwirkung. Die Temperatur beim Übergang aus der Flüssigphase beträgt typischerweise ca. -78°C.

Ein derart zielgerichtetes Kühlen mit sehr niedrigen Temperaturen des Kühlmediums wird auch als "kryogene Kühlung" bezeichnet. Eine solche Art und Weise der Kühlung zeichnet sich durch eine präzise und sehr schnelle Wärmeübertragung aus. Die hohe Verdampfungsenthalpie des flüssig eingespritzten Kühlmediums ermöglicht in Verbindung mit der dabei auftretenden niedrigen Temperatur eine äußerst effiziente Wärmeübertragung und schnelle Temperierung der Kontaktfläche und damit des zu der Kontaktfläche benachbarten Halbleiter-Bauelements.

Eine weitere Minimierung der zu erwärmenden bzw. abzukühlenden Massen wird durch eine besondere konstruktive Ausführung des Heizelements erreicht. Dabei wird, allgemein formuliert, die benötigte Kühlkammer durch das Heizelement bzw. Teile des Heizelements im Zusammenspiel mit dem Kühlmechanismus bzw. mit Teilen des Kühlmechanismus gebildet. Es gibt anders formuliert kein separat handhabbares "Kühlkammer-Bauteil".

In einer vorteilhaften Ausführungsform der Erfindung ist eine benachbart zu dem Heizelement bzw. benachbart zu der Kontaktfläche des Heizelements angeordnete Einspritzdüse für das Kühlmittel vorgesehen, welche in das Heizelement hineinragt und hierdurch wenigstens einen Teil der Kühlkammer bildet. Dabei begrenzt die Einspritzdüse die Kühlkammer wenigstens einseitig. Zugleich bildet die Öffnung der Einspritzdüse eine Einlaßöffnung der Kühlkammer. Vorzugsweise bildet die Einspritzdüse eine Decke der Kühlkammer, während die Kontaktfläche des Heizelements bzw. der die Kontaktfläche bildende Teil des Heizelements den der Decke gegenüberliegenden Boden der Kühlkammer bildet. Für eine besonders effiziente Wärmeübertragung zu der Kontaktfläche hat es sich als vorteilhaft erwiesen, daß die Öffnung der Einspritzdüse auf die Kontaktfläche zu gerichtet ist, genauer gesagt auf den Teil des Heizelements, der die Kontaktfläche bildet.

In einer Ausführungsform der Erfindung ist ein zu dem Heizelement, genauer gesagt zu dem die Kontaktfläche bildenden Teil des Heizelements benachbart angebrachtes, vorzugsweise hülsen- oder rohrförmiges Bauteil vorgesehen, das die über dem Heizelement plazierte Einspritzdüse aufnimmt, wobei ein Zwischenraum zwischen dem Bauteil und der Einspritzdüse eine Auslaßöffnung der Kühlkammer bildet. Vorzugsweise bildet dieses Bauteil zugleich einen weiteren Teil der Kühlkammer aus. Für einen besonders guten Wärmeübergang zu der Kontaktfläche hat es sich als vorteilhaft erwiesen, wenn dieses Bauteil aus einem geeigneten Material gefertigt und einteilig mit dem Heizelement verbunden ist.

Die Temperierung des zu testenden Halbleiter-Bauelements erfolgt gemäß einer Ausführungsform der Erfindung mit Hilfe einer geeigneten Steuerung. Demnach wird das Kältemittel auf kontrollierte Art und Weise verdampft. Die Steuerung der Temperierung erfolgt vorzugsweise unter Verwendung von Sensordaten eines oder mehrerer Temperatursensoren.

In einer bevorzugten Ausführungsform der Erfindung befindet sich dabei zumindest ein Temperatursensor im Testsockel, vorteilhafterweise unmittelbar unterhalb des zu testenden Halbleiter-Bauelements, d. h. auf der der Heizung gegenüberliegenden Seite des Bauelements. Die Verwendung eines so angeordneten Temperatursensors ist besonders vorteilhaft, da mit Hilfe der von diesem Sensor übermittelten Temperaturwerte sichergestellt werden kann, daß das Halbleiter-Bauelement, welches sich noch näher an der Kontaktfläche des Heizelements befindet, mindestens die angegebene Temperatur aufweist. Vorteilhafterweise befindet sich zumindest ein weiterer Temperatursensor in dem Thermoaufsatz, typischerweise in unmittelbarer Nähe der Kontaktfläche. Es ist jedoch ebenfalls möglich, zur Steuerung des Thermoaufsatzes (auch) solche Temperatursensoren zu verwenden, die, je nach Bauart, im Inneren des Halbleiter-Bauelements vorgesehen sein können.

In einer Ausführungsform der Erfindung erfolgt dann unter Verwendung der Temperaturdaten der Temperatursensoren, die als Eingangsdaten einer externen Steuerungseinheit dienen, die Steuerung der Temperierung der Kontaktfläche bzw. des Bauelements. Ein entsprechend ausgebildetes Steuergerät steuert einerseits die Funktion des Heizelements, nämlich unmittelbar über den am Heizelement angelegten Strom. Andererseits übernimmt das Steuergerät die Kontrolle des Kühlmechanismus, insbesondere das Ansteuern eines Kühlmittelventils in der Zuflußleitung zu der Einspritzdüse.

In einer bevorzugten Ausführungsform der Erfindung ist das Steuergerät derart ausgeführt, daß mit Hilfe des kombinierten Heiz-/Kühlelements entweder ein alleiniges Heizen oder ein alleiniges Kühlen der Kontaktfläche erfolgt oder aber es erfolgt die Ansteuerung für ein gleichzeitiges Heizen und Kühlen der Kontaktfläche. So ist es besonders von Vorteil, daß beim Erreichen einer gewünschten Hochtemperatur bereits vor dem Erreichen dieser Zieltemperatur Kühlmittel in die Kühlkammer eingelassen wird, um den Temperaturanstieg rasch zu stoppen und ein Überschießen des Temperaturzielwertes zu vermeiden. Hierzu kann ein schnelles, vorzugsweise gepulstes Öffnen und Schließen des Kühlmittelventils dienen, angesteuert von dem Steuergerät unter Verwendung geeigneter, vorzugsweise selbstlernender Steuerungsalgorithmen. Im Ergebnis findet kein oder nur ein minimales Über- bzw. Unterschwingen des Zieltemperaturwertes statt. Sobald die Zieltemperatur erreicht ist, pendelt sich die Temperatur rasch ein, bei einem Korridor von anfangs maximal +/-1,5 bis 2°C, rasch kleiner werdend.

Bei der Erfindung erfolgt somit ein gezieltes Heizen bzw. Kühlen. Es wird nur exakt dasjenige Bauteil geheizt bzw. gekühlt, welches das Ziel der Temperierung darstellt, nämlich das zu testende Halbleiter-Bauelement. Ein Temperatureintrag in den Sockel oder umliegende Bauteile usw. erfolgt nicht oder nur in einem zu vernachlässigendem Umfang. Daher sind an den das Halbleiter-Bauelement tragenden Sockel auch nur geringe Materialanforderungen zu stellen. Zugleich kann der Chip näher an anderen, temperaturkritischen Bauteilen und Komponenten angeordnet sein, als dies bei den aus dem Stand der Technik bekannten Lösungen möglich und erlaubt ist.

Aufgrund des zielgenauen Wärmeeintrags ist mit Hilfe der Erfindung zugleich eine bauteilindividuelle Temperaturkontrolle möglich. Während bisher der sogenannte Burn-in-Test stets als Massentest in einem Ofen durchgeführt wurde, können jetzt einzelne, diskrete Chips innerhalb kürzester Zeit bei Hochtemperatur bzw. in einem weiten Temperaturbereich getestet werden, dies bei gleichzeitigem umfassenden Zugriff eines Testingenieurs oder Programmierers auf alle Chipfunktionen während des Tests.

Nachfolgend wird ein typischer Testverlauf gemäß einer besonders bevorzugten Ausführungsform der Erfindung beschrieben. Der Thermoaufsatz wird mit der Kontaktfläche des Heizelements auf die Oberseite des Halbleiter-Bauelements aufgesetzt. Der Thermoaufsatz umfaßt ein Heizelement, mindestens einen Temperatursensor sowie einen Kühlmechanismus. Über den wenigstens einen Temperatursensor werden der Kühlmittelfluß und das wenigstens eine integrierte Heizelemente angesteuert, so daß sich schnell eine gewünschte Bauteiltemperatur erreichen und diese sehr genau auf einem zuvor definierten Wert halten läßt. Die Kühlung erfolgt vorzugsweise mit Hilfe eines offenen Kreislaufs. Das Kühlmittel kann die von dem Bauelement erzeugte Wärme abführen. Es ist somit möglich, die Temperatur jedes einzelnen Bauelements unabhängig von der jeweils individuell erzeugten Eigenerwärmung einzustellen.

Ein Ausführungsbeispiel der Erfindung wird nachfolgend anhand der Zeichnungen näher erläutert. Hierbei zeigen:

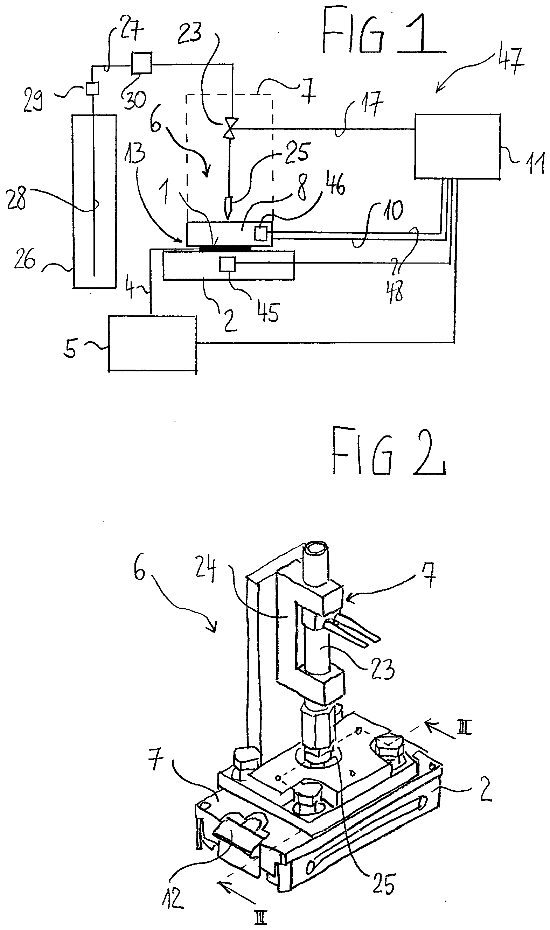

- Fig. 1: eine schematische Darstellung der Testanlage,
- Fig. 2: eine perspektivische Ansicht eines Testsockels mit Thermoaufsatz,

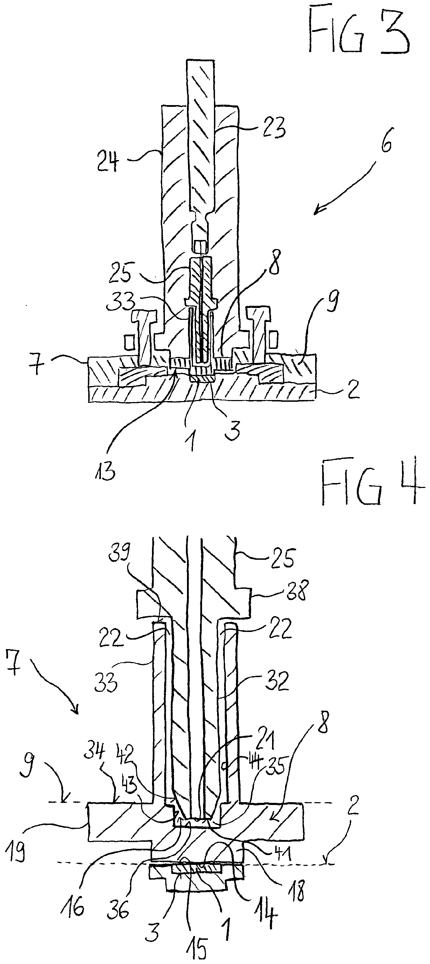

- Fig. 3: einen Schnitt durch die Testvorrichtung entlang Linie III-III in Fig. 2,
- Fig. 4: eine Detailansicht aus Fig. 3,
- Fig. 5: eine Detailansicht aus Fig. 4.

Sämtliche Figuren zeigen die Erfindung nicht maßstabsgerecht, dabei lediglich schematisch und nur mit ihren wesentlichen Bestandteilen. Gleiche Bezugszeichen entsprechen dabei Elementen gleicher oder vergleichbarer Funktion.

Ein zu testendes diskretes Halbleiter-Bauelement 1 ist in einem Testsockel 2 aufgenommen. Es liegt zu diesem Zweck in einer dafür vorgesehenen Aufnahme 3 ein. Bei dem Halbleiter-Bauelement 1 handelt es sich um einen ungehäusten Chip. Der Chip ist über elektrische Kontaktierungsleitungen 4 mit einem Kontrollrechner 5 verbunden, der den 1 Chip während des Tests mit unterschiedlichen Betriebsspannungen und Testsignalen beaufschlagen und auf diese Weise die Funktionstüchtigkeit des Chips 1 testen wird.

Eine erfindungsgemäße Testvorrichtung 6 umfaßt einen auf den Testsockel 2 aufsetzbaren Thermoaufsatz 7, der ein keramisches Heizelement 8 aufweist. Das Heizelement 8 ist in einem geeigneten Träger 9 angeordnet. Weitere, das Heizelement 8 umgebende Bauteile dienen der Isolation und dem Berührungsschutz. Das Heizelement 8 ist über eine Versorgungsleitung 10 an ein Steuergerät 11 angeschlossen, welches zugleich zur elektrischen Stromversorgung des Heizelements 8 dient und die Steuerung der Stromversorgung des Heizelements 8 übernimmt.

Der Thermoaufsatz 7 ist mit Hilfe einer Klinkenverriegelung oder einer anderen geeigneten Verriegelung mit dem Sockel 2 verbindbar, hier unter Verwendung eines Hebelmechanismus mit seitlich angebrachten, manuell betätigbaren Hebelarmen 12.

Das an der Unterseite 13 des Thermoaufsatzes 7 angebrachte Heizelement 8 weist eine nach unten zeigende, auf den Testsockel 2 zu gerichtete ebene Kontaktfläche 14 auf. Im montierten Zustand und während des Testens liegt diese Kontaktfläche 14 flächig an der Oberseite 15 des in dem Sockel 2 gehaltenen Halbleiter-Bauelements 1 an.

Das Heizelement 8 ist nicht nur zum Heizen sondern auch zum Kühlen der Kontaktfläche 14 ausgebildet. Hierzu weist das Heizelement 8 einen zu der Kontaktfläche 14 benachbarten Aufnahmeraum 16 zur Aufnahme eines Kühlmittels, hier CO2-Flüssiggas, auf. Diese Kühlkammer 16 ist oberhalb des an seiner Unterseite die Kontaktfläche 14 bildenden Bodenteils 18 des Grundkörpers 19 des Heizelements 8 vorgesehen.

Die Kühlkammer 16 ist zum Durchströmen des Kühlmittels ausgebildet und weist zu diesem Zweck eine Einlaßöffnung 21 und eine Auslaßöffnung 22 auf. Die Besonderheit hierbei ist, daß die Kühlkammer 16 im Heizelement 8 integriert ist. Dadurch ist die Masse der temperaturaufnehmenden Teile sehr gering. Dies trägt wesentlich dazu bei, daß die gewünschte Zieltemperatur besonders schnell erreicht und besonders einfach innerhalb einer schmalen Temperaturbandbreite gehalten werden kann.

Der Thermoaufsatz 7 umfaßt weiterhin ein Ventil 23 mit Ventilhalterung 24 sowie eine Einspritzdüse 25. Das Ventil 23 mit Anschluß an einen CO2-Kältemittelvorratsbehälter 26 wird von der mit dem Träger 9 verbundenen Ventilhalterung 24 gehalten. Das schaltbare Ventil 23 ist über eine Signalleitung 17 mit dem Steuergerät 11 verbunden und kann mittels des Steuergerätes 11 schnell hintereinander geöffnet und geschlossen werden.

Für den Kühlmechanismus wird ein spezielles Zuführsystem verwendet, beispielsweise umfassend eine Isolierflasche 26 zur Speicherung des Kältemittels, vakuumisolierte Schläuche 27, spezielle Tieftemperatur-Schaltventile 23 usw.

Zur Entnahme von CO2 aus der Druckflasche 26 dient ein bis zum Flaschengrund reichendes Steigrohr 28. Ein Filter 29 dient zum Herausfiltern von Verunreinigungen aus dem Kältemittel. Ein Druckminderer 30 dient dazu, den Flaschendruck von beispielsweise 200 bar auf einen Arbeitsdruck von ca. 50 bis 55 bar zu vermindern.

Das ansteuerbare Ventil 23 ist mit der Einspritzdüse 25 verbunden, die auf das Heizelement 8 zu gerichtet montiert ist. Der eigentliche Düsenkopf 32 der Einspritzdüse 25 liegt mit der Düsenöffnung 21 nach unten weisend in einem hülsen- oder rohrförmigen Bauteil ein. Dieses nachfolgend als Kammerhülse 33 bezeichnete Bauteil ist senkrecht auf dem Grundkörper 19 des Heizelements 8 angeordnet.

Der Grundkörper 19 des Heizelements 8 weist an seiner Oberseite 34 eine Aufnahme 35 in Form einer Vertiefung auf, welche zugleich den ebenen Boden 36 der Kühlkammer 16 bildet. Dieser Boden 36 der Kühlkammer 16 liegt parallel der Kontaktfläche 14 des Heizelements 8 gegenüber, beabstandet von der Kontaktfläche 14 durch das Bodenteil 18 des Grundkörpers 19. In diese Aufnahme 35 taucht die Einspritzdüse 25, genauer gesagt der Düsenkopf 32 der Einspritzdüse 25 mit der Düsenöffnung 21 ein. Damit ist die Einspritzdüse 25 unmittelbar benachbart zu dem Heizelement 8 angeordnet. Aufgrund dieser Anordnung wird die Decke der Kühlkammer 16 durch die Stirnseite 41 der Düse 25 gebildet, durch welche das Kältemittel in die Kühlkammer 16 eingeleitet wird. Die Düse 25 begrenzt somit ebenfalls einen Teil der Kühlkammer 16. Dabei bildet die Düsenöffnung 21 die Einlaßöffnung der Kühlkammer 16. Die Düsenöffnung 21 ist senkrecht und auf den Kühlkammerboden 36 zu gerichtet und zugleich mittig in der Aufnahme 35 und damit mittig über der Kontaktfläche 14 plaziert. Die Einspritzdüse 25 liegt mit einer umlaufenden Auskragung 38 auf dem oberen Freiende 39 der Kammerhülse 33 auf, wodurch auf einfache Weise die geeignete Position der Düse 25 in der Aufnahme 35 und die Kühlkammerhöhe zwischen Kühlkammerboden 36 und Einspritzdüse 25 festgelegt ist.

Die Kühlkammer 16 im Inneren des Thermoaufsatzes 7 wird somit einerseits gebildet durch den Raum zwischen der Stirnseite 41 der Düse 25 und dem Boden 36 der Aufnahme 35 sowie andererseits durch den Raum zwischen dem Außenmantel 42 der Düse 25 im Bereich des Freiendes des Düsenkopfes 32 und den Seitenwänden 43 der Aufnahme 35 und darüber hinaus durch den Raum zwischen dem Außenmantel 42 der Düse 25 außerhalb der Aufnahme 35 und dem Innenmantel 44 der Kammerhülse 33 in einem zu dem Heizelement 8 benachbarten, unteren Bereich oberhalb des Grundkörpers 19 des Heizelements 8.

Die Kühlkammer 16 wird anders ausgedrückt definiert durch denjenigen Raum, in welchem aus der Öffnung 21 der Düse 25 ausgetretenes und verdampftes Kältemittel effektiv Kälte, die für eine Temperierung der Kontaktfläche 14 nutzbar ist, an das Heizelement 8 sowie an zu dem Heizelement 8 unmittelbar benachbarte Bauteile, wie die Kammerhülse 33, abgibt. Die Kälteenergie aufnehmenden Teile der Kühlkammer 16 sind somit insbesondere der von dem Heizelement 8 gebildete Kammerboden 36, die Kammerwände 43 und die Innenseite 44 der Kammerhülse 33 in einem sich unmittelbar an das Heizelement 8 anschließenden Bereich. Die Düse 25 selbst ist vorzugsweise aus einem thermisch isolierenden Material gefertigt.

Die Kammerhülse 33 ist mit dem Grundkörper 19 des Heizelements 8 verbunden in einem Bereich, der benachbart zu der Aufnahme 35 ist. Dabei umschließt die Kammerhülse 33 den Bereich der Aufnahme 35 vollständig. Bei einem Kälteeintrag über die Kühlkammer 16 in die Kammerhülse 33 erfolgt somit eine zusätzliche Übertragung der Kälteenergie von der Kammerhülse 33 in zu der Aufnahme 35 benachbarte Bereiche des Grundkörpers 19, insbesondere in die Bereiche der Seitenwände 43, von wo aus es zu einer Wärmeleitung über das Bodenteil 18 in die Kontaktfläche 14 kommt.

Der sich an den noch der Kühlkammer 16 zuzurechnenden unteren Bereich des Zwischenraumes zwischen dem Außenmantel 42 der Düse 25 und dem Innenmantel 44 der Kammerhülse 33 nach oben anschließende Bereich des Zwischenraums dient als Auslaßöffnung 22 für das verbrauchte Kühlmittel. Die übrigen Teile des Thermoaufsatzes 7 dienen hauptsächlich der Isolation und schützen den Bediener vor Verbrennungen.

Um eine Vereisung und damit eine Verstopfung der Kältemittelzuführung 27, 25 zu vermeiden, ist der Kühlmechanismus vorzugsweise derart eingestellt, daß der CO2-Durchsatz nicht höher ist, als unbedingt nötig, um die angestrebte Kühlwirkung zu erreichen. Das Steuergerät 11 ist entsprechend ausgebildet.

Eine ungewollte Eisbildung am Heizelement 8 bzw. allgemein in der Nähe der Düse 25 wird üblicherweise durch Feuchtigkeit der Umgebungsluft hervorgerufen. Eine Lösung hierfür ist der Betrieb des Kühlmechanismus bzw. der Testvorrichtung 6 in einer kontrollierten Atmosphäre, z. B. in vorgereinigter Luft, trockener Luft oder unter Gasatmosphäre, wie beispielsweise in einer geschlossenen Kammer.

Der CO2-Druck wird innerhalb der Zuführleitungen 27, 25 zu der Kühlkammer 16 solange wie möglich aufrechterhalten, damit das Kältemittel solange wie möglich flüssig bleibt und eine Verdampfung bereits vor dem Erreichen der Kühlkammer 16 vermieden wird. Unmittelbar nach dem Eintritt des Kältemittels in die Kühlkammer 16 erfolgt dann ein Verdampfen und die Übertragung der Wärme (Kälte) auf die Kontaktfläche 14, genauer gesagt auf das Bodenteil 18 des Heizelements 8, das die Kühlkammer 16 von der Kontaktfläche 14 trennt, von wo aus dann unmittelbar über Wärmeleitung eine Kühlung der Kontaktfläche 14 erfolgt.

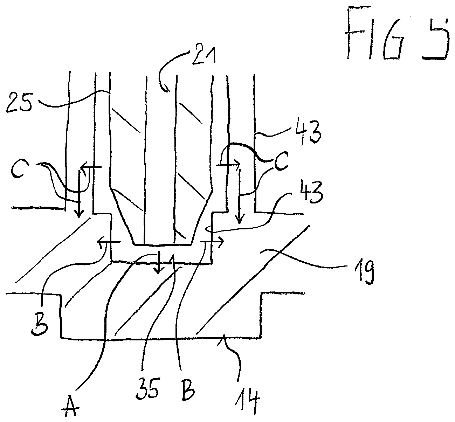

Im Bereich des Bodens 36 der Kühlkammer 16 erfolgt folgerichtig der größte Teil des Kälteeintrags aus der Kühlkammer 16 in das Heizelement 8, entlang Pfeil A, wie in Fig. 5 illustriert. Ein weiterer Teil des Kälteeintrags in das Heizelement 8 erfolgt über die seitlichen Wände 43 der Aufnahme 35, welche ebenfalls durch den Grundkörper 19 des Heizelements 8 gebildet sind, entlang Pfeil B.

Während der Hauptkälteeintrag somit unmittelbar von dem unteren, durch die Aufnahme 35 definierten Abschnitt der Kühlkammer 16 in das Heizelement 8 erfolgt, findet ein weiterer Teil des Kühleintrags in den Grundkörper 19 des Heizelements 8 auch von dem oberen, durch die Kammerhülse 33 definierten Abschnitt der Kühlkammer 16 in die durch die Kammerhülse 33 gebildeten Kühlkammerwände statt, nämlich entlang Pfeil C. Die innere Mantelfläche 44 der Kammerhülse 33 begrenzt anders ausgedrückt einen für die zu erreichende Kühlfunktion nicht unwesentlichen Teil der Kühlkammer 16.

Mittels einer geeigneten Materialauswahl und durch eine einteilige Ausführung von Heizelement 8 und Kammerhülse 33 kann sichergestellt werden, daß ein Kälteeintrag in das Heizelement 8 auch über die zuvor heruntergekühlte Kammerhülse 33 entlang Pfeil C erfolgt. Eine einteilige Ausführung von Heizelement 8 und Kammerhülse 33 erfolgt vorzugsweise unter Ausbildung einer geeigneten Verbindung der Kammerhülse 33 mit dem Heizelement 8, dies vorzugsweise unter Verwendung einer Löt- oder Schweißverbindung. Zugleich ist die Kammerhülse 33 zu diesem Zweck aus einem Material gefertigt, daß eine besonders gute Wärmeübertragung von und zu dem Heizelement 8 ermöglicht.

Unterhalb des Halbleiter-Bauelements 1 ist in dem Testsockel 2 ein Temperatursensor 45 vorgesehen, der über eine Sensorleitung 48 mit dem Steuergerät 11 verbunden ist. Ein weiterer Temperatursensor 46 befindet sich in dem Thermoaufsatz 7. Das Steuergerät 11 fragt die aktuelle Temperatur an den Temperatursensoren 45, 46 ab und vergleicht diese Temperaturen mit einer voreingestellten Testtemperatur. Dabei kann es sich um eine manuell eingestellte einzelne Testtemperatur oder um eine Testtemperatur innerhalb eines umfangreichen Testzyklus handeln. Entsprechend der abgefragten Temperatur kontrolliert das Steuergerät 11 entweder das Heizelement 8, um das Halbleiter-Bauelement 1 über die Kontaktfläche 14 aufzuheizen, oder das Ventil 23, um das Bauelement 1 über die Kontaktfläche 14 zu kühlen, wobei durch das Verdampfen (Volumen- und Druckänderung) des CO2 eine Abkühlung herbeigeführt wird.

Nähert sich die Ist-Temperatur der Soll-Temperatur, also der zu erreichenden Zieltemperatur des Halbleiter-Bauelements 1 für den nächsten durchzuführenden Test, beginnt das Steuergerät 11 selbständig die Aktivierung der beiden Einflußfaktoren (Heizung, Kühlung) zu pulsen, um das zu testende Bauteil 1 in einer Temperaturbandbreite von plus/minus 1,5°C zur Soll-Temperatur zu halten. Dabei können Heizung und Kühlung erneut wahlweise, also abwechselnd, oder aber auch gleichzeitig betrieben werden, um einen optimalen Temperaturverlauf zu erreichen. So kann bei einem Herunterkühlen vor dem Erreichen der Zieltemperatur zusätzlich zu dem aktivierten Kühlmechanismus 23, 25 das Heizelement 8 eingeschaltet werden oder bei einem Erwärmen kann vor dem Erreichen der Zieltemperatur zusätzlich zu dem Heizelement 8 der Kühlmechanismus 23, 25 aktiviert werden. In beiden Fällen kann das kombinierte Betreiben von Heizung und Kühlung das Einstellen der Soll-Temperatur deutlich beschleunigen. Das zu testende Bauteil 1 kann auf diese Weise einfach und schnell bei einer definierten Temperatur zwischen -55°C und +260°C getestet werden.

Testsockel 2, Thermoaufsatz 7 und Kältemitteleinrichtungen 23, 25 bilden zusammen mit dem Steuergerät 11 und dem Kontrollrechner 5 eine Testanlage 47, die einfach durch weitere Sockel 2 mit Thermoaufsatz 7 ergänzt werden kann.

### Bezugszeichenliste

- 1: Halbleiter-Bauelement
- 2: Testsockel
- 3: Aufnahme
- 4: Leitung
- 5: Kontrollrechner
- 6: Testvorrichtung
- 7: Thermoaufsatz
- 8: Heizelement
- 9: Träger
- 10: elektrische Versorgungsleitung
- 11: Steuergerät
- 12: Hebelarm
- 13: Unterseite des Thermoaufsatzes
- 14: Kontaktfläche
- 15: Oberseite des Bauelements
- 16: Aufnahmeraum, Kühlkammer
- 17: Signalleitung
- 18: Bodenteil des Grundkörpers
- 19: Grundkörper
- 20: (frei)
- 21: Einlaßöffnung, Düsenöffnung
- 22: Auslaßöffnung
- 23: Ventil
- 24: Ventilhalterung
- 25: Einspritzdüse
- 26: Vorratsbehälter
- 27: Schlauch
- 28: Steigrohr
- 29: Filter
- 30: Druckminderer
- 31: (frei)
- 32: Düsenkopf
- 33: Kammerhülse
- 34: Oberseite des Grundkörpers
- 35: Aufnahme
- 36: Kühlkammerboden
- 37: (frei)
- 38: Auskragung
- 39: Freiende der Kammerhülse
- 40: (frei)
- 41: Stirnseite der Düse
- 42: Außenmantel der Düse
- 43: Seitenwand
- 44: Innenmantel der Kammerhülse
- 45: Temperatursensor
- 46: Temperatursensor
- 47: Testanlage
- 48: Sensorleitung

## Patentansprüche

1. Testvorrichtung (6) für ein diskretes Halbleiter-Bauelement (1), mit einem Thermoaufsatz (7), welcher Thermoaufsatz (7) ein Heizelement (8) umfaßt, wobei das Heizelement (8) ein keramisches Heizelement ist, nämlich ein keramisches Schichtheizelement oder ein vollkeramisches Heizelement, bei dem unter Nutzung der elektrisch halbleitenden Eigenschaften von Keramiken die Beheizung direkt über den elektrischen Stromfluß erfolgt, wobei das Heizelement (8) eine beheizbare Kontaktfläche (14) aufweist, **dadurch gekennzeichnet, daß** die beheizbare Kontaktfläche (14) während des Testens an dem Halbleiter-Bauelement (1) anlegbar ist, wobei das Heizelement (8) zum Heizen und zum Kühlen der beheizbaren Kontaktfläche (14) ausgebildet ist, zu welchem Zweck im Inneren des Heizelements (8) ein zu der Kontaktfläche (14) benachbarter, als Kühlkammer zum Kühlen der Kontaktfläche (14) dienender Aufnahmeraum (16) zur Aufnahme eines flüssigen, dort verdampfenden Kühlmittels vorgesehen ist.

2. Testvorrichtung (6) nach Anspruch 1, **dadurch gekennzeichnet, daß** die Kühlkammer (16) zum Durchströmen des Kühlmittels ausgebildet ist und zu diesem Zweck wenigstens eine Einlaßöffnung (21) und wenigstens eine Auslaßöffnung (22) aufweist.

3. Testvorrichtung (6) nach Anspruch 2, **gekennzeichnet durch** eine benachbart zu dem Heizelement (8) angeordnete Einspritzdüse (25) für das Kühlmittel, welche die Kühlkammer (16) wenigstens einseitig begrenzt, wobei die Öffnung (21) der Einspritzdüse (25) eine Einlaßöffnung der Kühlkammer (16) bildet.

4. Testvorrichtung (6) nach Anspruch 3, **gekennzeichnet durch** ein zu dem Heizelement (8) benachbart angebrachtes Bauteil (33), welches die Einspritzdüse (25) aufnimmt, wobei ein Zwischenraum (22) zwischen dem Bauteil (33) und der Einspritzdüse (25) eine Auslaßöffnung der Kühlkammer (16) bildet.

5. Testvorrichtung (6) nach Anspruch 4, **dadurch gekennzeichnet, daß** dieses Bauteil (33) einen Teil der Kühlkammer (16) ausbildet.

6. Testvorrichtung (6) nach Anspruch 4 oder 5, **dadurch gekennzeichnet, daß** dieses Bauteil (33) einteilig mit dem Heizelement (8) verbunden ist.

7. Verfahren zum Testen eines diskreten Halbleiter-Bauelements (1) mit einer Testvorrichtung nach einem der Ansprüche 1 bis 6, **dadurch gekennzeichnet, daß** die beheizbare Kontaktfläche (14) des Heizelements (8) des auf den Testsockel (2) aufsetzbaren Thermoaufsatzes (7) an dem in dem Testsockel (2) aufgenommenen Halbleiter-Bauelement (1) anliegt, wobei auf kontrollierte Art und Weise ein flüssiges Kühlmittel in die benachbart zu der Kontaktfläche (14) vorgesehene Kühlkammer (16) im Inneren des Heizelements (8) eingebracht wird und dort verdampft, wobei ein wahlweises Heizen oder Kühlen oder ein gleichzeitiges Heizen und Kühlen der Kontaktfläche (14) erfolgt, wobei das Heizen mit Hilfe des Heizelements (8) erfolgt, das ein keramisches Heizelement ist, nämlich ein keramisches Schichtheizelement oder ein vollkeramisches Heizelement, bei dem unter Nutzung der elektrisch halbleitenden Eigenschaften von Keramiken die Beheizung direkt über den elektrischen Stromfluß erfolgt.

## Claims

1. Test device (6) for a discrete semiconductor component (1), having a thermal attachment (7), which thermal attachment (7) comprises a heating element (8), wherein the heating element (8) is a ceramic heating element, specifically a ceramic film heating element or a fully ceramic heating element, with which, through the use of the electrically semiconducting properties of ceramics, the heating is realized directly via the electrical current flow, wherein the heating element (8) has a heatable contact surface (14), **characterized in that** the heatable contact surface (14) is positionable against the semiconductor component (1) during the testing, wherein the heating element (8) is designed for heating and for cooling the heatable contact surface (14), for which purpose a receiving space (16) is provided in the interior of the heating element (8) for receiving a liquid cooling medium which evaporates there, which receiving space (16) being adjacent to the contact surface (14) and serving as a cooling chamber for cooling the contact surface (14).

2. Test device (6) according to Claim 1, **characterized in that** the cooling chamber (16) is designed for the throughflow of the cooling medium and, for this purpose, has at least one inlet opening (21) and at least one outlet opening (22).

3. Test device (6) according to Claim 2, **characterized by** an injection nozzle (25) for the cooling medium, which is arranged adjacent to the heating element (8) and delimits the cooling chamber (16) at least on one side, wherein the opening (21) of the injection nozzle (25) forms an inlet opening of the cooling chamber (16).

4. Test device (6) according to Claim 3, **characterized by** a component (33) which is affixed adjacent to the heating element (8) and which accommodates the injection nozzle (25), wherein an intermediate space (22) between the component (33) and the injection nozzle (25) forms an outlet opening of the cooling chamber (16).

5. Test device (6) according to Claim 4, **characterized in that** said component (33) forms a part of the cooling chamber (16).

6. Test device (6) according to Claim 4 or 5, **characterized in that** said component (33) is integrally connected to the heating element (8).

7. Method for testing a discrete semiconductor component (1) using a test device according to one of Claims 1 to 6, **characterized in that** the heatable contact surface (14) of the heating element (8) of the thermal attachment (7), which attachment is able to be mounted on the test base (2), is positioned against the semiconductor component (1), which is accommodated in the test base (2), wherein, in a controlled manner, a liquid cooling medium is introduced into the cooling chamber (16), provided adjacent to the contact surface (14), in the interior of the heating element (8) and evaporates there, wherein optional heating or cooling, or simultaneous heating and cooling, of the contact surface (14) is realized, wherein the heating is realized with the aid of the heating element (8), which is a ceramic heating element, specifically a ceramic film heating element or a fully ceramic heating element, with which, through the use of the electrically semiconducting properties of ceramics, the heating is realized directly via the electrical current flow.

## Revendications

1. Dispositif de test (6) pour un composant semi-conducteur discret (1), comportant une fixation thermique (7), laquelle fixation thermique (7) comprend un élément chauffant (8), dans lequel l'élément chauffant (8) est un élément chauffant céramique, à savoir un élément chauffant à couche céramique ou un élément chauffant tout céramique, dans lequel le chauffage est effectué directement par l'intermédiaire du flux de courant électrique en utilisant les propriétés électriquement semi-conductrices des céramiques, dans lequel l'élément chauffant (8) présente une surface de contact pouvant être chauffée (14),
**caractérisé en ce que** la surface de contact pouvant être chauffée (14) peut être appliquée sur le composant semi-conducteur (1) pendant le test, dans lequel l'élément chauffant (8) est conçu pour chauffer et pour refroidir la surface de contact pouvant être chauffée (14), un espace de réception (16), adjacent à la surface de contact (14) et servant de chambre de refroidissement destinée à refroidir la surface de contact (14), étant prévu à cet effet à l'intérieur de l'élément chauffant (8) pour recevoir un liquide de refroidissement qui s'y évapore.

2. Dispositif de test (6) selon la revendication 1, **caractérisé en ce que** la chambre de refroidissement (16) est conçue pour la circulation du fluide caloporteur et comporte à cet effet au moins une ouverture d'entrée (21) et au moins une ouverture de sortie (22).

3. Dispositif de test (6) selon la revendication 2, **caractérisé par** une buse d'injection (25) destinée au fluide caloporteur, qui est disposée près de l'élément chauffant (8) et délimite au moins d'un côté la chambre de refroidissement (16), dans lequel l'ouverture (21) de la buse d'injection (25) forme une ouverture d'entrée de la chambre de refroidissement (16) .

4. Dispositif de test (6) selon la revendication 3, **caractérisé par** un composant (33) qui est monté près de l'élément chauffant (8) et qui reçoit la buse d'injection (25), dans lequel un espace intermédiaire (22) entre le composant (33) et la buse d'injection (25) forme une ouverture de sortie de la chambre de refroidissement (16).

5. Dispositif de test (6) selon la revendication 4, **caractérisé en ce que** ledit composant (33) fait partie de la chambre de refroidissement (16).

6. Dispositif de test (6) selon la revendication 4 ou 5, **caractérisé en ce que** ledit composant (33) est relié en une seule pièce à l'élément chauffant (8).

7. Procédé pour tester un composant semi-conducteur discret (1) comportant un dispositif de test selon l'une des revendications 1 à 6, **caractérisé en ce que** la surface de contact pouvant être chauffée (14) de l'élément chauffant (8) de la fixation thermique (7) pouvant être montée sur le socle de test (2), repose sur le composant semi-conducteur (1) reçu dans le socle de test (2), dans lequel un fluide caloporteur liquide est introduit de manière contrôlée dans la chambre de refroidissement (16) prévue près de la surface de contact (14) à l'intérieur de l'élément chauffant (8) et s'y évapore, dans lequel un chauffage ou un refroidissement facultatif ou un chauffage et un refroidissement simultanés de la surface de contact (14) sont effectués, dans lequel le chauffage est effectué à l'aide de l'élément chauffant (8), qui est un élément chauffant céramique, à savoir un élément chauffant à couche céramique ou un élément chauffant tout céramique, dans lequel le chauffage est effectué directement par l'intermédiaire du flux de courant électrique en utilisant les propriétés électriquement semi-conductrices des céramiques.
